# EUROPÄISCHE PATENTSCHRIFT

(11) **EP 1 667 199 B1**
(45) Veröffentlichungstag und Bekanntmachung des Hinweises auf die Patenterteilung: **20.04.2011**
(21) Anmeldenummer: 05026467.0
(22) Anmeldetag: 05.12.2005
(51) Int. Cl.: H01J 37/32

(54) **Mikrowellenplasmaquelle**
Microwave plasma source
Source à plasma micro-onde

(30) Priorität: 06.12.2004 DE 102004060068
(43) Veröffentlichungstag der Anmeldung: 07.06.2006
(73) Patentinhaber: Fraunhofer-Gesellschaft zur Förderung der angewandten Forschung e.V., 80686 München (DE)
(72) Erfinder: Mäder, Gerrit, 01187 Dresden (DE); Rogler, Daniela, 01277 Dresden (DE); Hopfe, Volkmar, 01814 Kleingiesshübel (DE); Krause, Steffen, 01277 Dresden (DE); Spitzl, Ralf, 53842 Troisdorf (DE)
(74) Vertreter: Pfenning, Meinig & Partner GbR

(56) Entgegenhaltungen:
- EP-A- 0 449 081
- WO-A-98/59359
- DE-A1- 10 239 875
- US-A- 5 517 085
- US-A- 5 998 986

## Beschreibung

Die Erfindung betrifft eine Mikrowellenplasmaquelle, bei der eine Plasmakammer von einem Mikrowellen-Resonator umschlossen ist. Dabei kann das in der Mikrowellenplasmaquelle gebildete Plasma aus der Plasmakammer über mindestens eine, bevorzugt mehrere Plasmaaustrittsdüse(n) ausgetrieben und beispielsweise für eine Oberflächenmodifizierung von Substratoberflächen oder zur Partikelherstellung/-bildung in der Gasphase eingesetzt werden.

Mit der Erfindung kann bei Atmosphärendruckbedingungen, zumindest jedoch in der Nähe des Umgebungsatmosphärendruckes gearbeitet werden. Es können die unterschiedlichsten Oberflächenmodifizierungstechnologien, wie beispielsweise ein Remote AP-PECVD (Atmospheric Pressure Plasma Enhanced Chemical Vapour Deposition), das Direkt-Plasma AP-PECVD, ein Hybrid AP-PECVD, also eine Kombination von Direkt- und Remote-Technik durchgeführt werden.

Außerdem können Composit-Beschichtungen auf Substratoberflächen ausgebildet werden, wobei eine In-situ Nano-Partikelbildung im Beschichtungsprozess ausgenutzt werden kann.

In einer weiteren Variante kann das Mikrowellenplasma auch vorteilhaft zur Herstellung von Partikeln in der Gasphase bevorzugt zur Bildung von Nanopartikeln mit einer schmalen Verteilungsfunktion ausgenutzt werden.

Die Erfindung baut auf Mikrowellenplasmaquellen auf, wie sie in WO 98/59359 A1 beschrieben sind.

Dabei ist eine Plasmakammer, die bevorzugt in Form eines Hohlzylinders ausgebildet ist, von einem Mikrowellen-Resonator umschlossen, über den Mikrowellen eines Mikrowellengenerators unter Einhaltung von Resonanzbedingungen, zumindest jedoch annähernd Resonanzbedingungen über verteilte Schlitzantennen in die Plasmakammer eingekoppelt werden. Mit einem in die Plasmakammer zugeführtem Plasmagas kann durch die zugeführte Mikrowellenenergie ein Plasma gebildet werden, das aus einer oder bevorzugt auch mehreren Plasmaaustrittsdüsen, die in einer Stirnfläche der Plasmakammer ausgebildet sind, ausgetrieben und dann das Plasma für eine Oberflächenmodifizierung von Substraten oder zur Bildung von Nanopartikeln in der Gasphase genutzt werden kann.

Weiter auf diese Lösung aufbauend, wird in DE 102 39 875 A1 darauf hingewiesen, dass neben dem Plasmagas ein weiterer Gasstrom in die Plasmakammer eingeführt werden kann, mit dem eine Spülung und Kühlung innerhalb der Plasmakammer erreichbar ist. Diese Gasströmung soll bevorzugt parallel zur inneren Mantelfläche einer zylindrischen Plasmakammer, ausgehend von einer der beiden Stirnseiten der Plasmakammer geführt werden.

Es hat sich nun aber gezeigt, dass mit einer solchen modifizierten Mikrowellenplasmaquelle zwar eine Verbesserung der Kühlung, eine Verhinderung des Anhaftens von Partikeln an der inneren Mantelfläche und auch eine geringfügige Verbesserung der Strömungsverhältnisse innerhalb der Plasmakammer erreicht werden können, dass aber insbesondere bezüglich der Strömungsverhältnisse innerhalb der Plasmakammer und der Ausnutzung der Mikrowellenleistung für den Remote-Plasmaprozess noch erhebliche Defizite zu verzeichnen sind. Diese betreffen beispielsweise unerwünschte, tief in die Plasmakammer hineinreichende Turbulenzen, in denen das gebildete Plasma in Form von Rollbewegungen strömt, ohne dass die in die interne Strömung eingekoppelte Mikrowellenleistung effektiv für Plasmaprozesse außerhalb der Kammer ausgenutzt werden kann.

Hierdurch treten insbesondere unerwünschte unterschiedliche Verweilzeiten von innerhalb der Plasmakammer gebildeten Plasmabestandteilen auf, bevor diese aus der Plasmakammer ausgetrieben werden. Solche unterschiedlichen Verweilzeiten führen aber auch zu unerwünschter unterschiedlicher Konsistenz des ausgebildeten Plasmas, wobei dies insbesondere dann kritisch ist, wenn neben dem Plasmagas zusätzlich mindestens ein Prekursor in die Plasmakammer eingeführt wird, mit dem Nano-Partikel in-situ gebildet werden sollen. Dadurch weisen die gebildeten Nano-Partikel unterschiedliche Korngrößen, innerhalb eines Korngrößenspektrums auf, was sowohl bei einer Ausbildung von Composit-Oberflächenbeschichtungen mit Nano-Partikeln als auch bei der Herstellung von Nano-Partikeln häufig unerwünscht ist. Außerdem können durch die relativ großen Verweilzeiten der Partikel innerhalb der Plasmakammer und durch Agglomeration auch größere Partikel in unerwünschter Form gebildet und in eine Schicht auf einem Substrat eingebettet werden.

Ein weiterer Nachteil, der bei den bekannten Mikrowellenplasmaquellen auftritt, sind auch Inhomogenitäten des gebildeten Plasmas, die lokal differenziert innerhalb der Plasmakammer auftreten. Dies trifft insbesondere auf die jeweils lokal unterschiedlich erreichbaren Plasmadichten innerhalb der Plasmakammer zu.

Außerdem sind in US 5,998,986 ein Verfahren und eine Vorrichtung zum Reinigen von Proben beschrieben. Dabei soll mit Mikrowellenenergie, einem Magnetfeld und zugeführtem Reaktionsgas ein Plasma gebildet und das Plasma durch ein in einem Drosselelement ausgebildetes Bestrahlungsloch auf die Probe gerichtet werden.

Es ist daher Aufgabe der Erfindung, Mikrowellenplasmaquellen dahingehend zu verbessern, dass innerhalb einer Plasmakammer ein homogeneres Plasma gebildet werden kann und eine kürzere, nahezu konstante Verweilzeit des gebildeten Plasmas innerhalb der Plasmakammer vor dem Austreiben aus der Plasmakammer erreicht werden kann.

Erfindungsgemäß wird diese Aufgabe mit einer Mikrowellenplasmaquelle, die die Merkmale des Anspruchs 1 aufweist, gelöst.

Vorteilhafte Ausgestaltungsformen und Weiterbildungen der Erfindung können mit den in den untergeordneten Ansprüchen bezeichneten Merkmalen erreicht werden.

Die erfindungsgemäße Mikrowellenplasmaquelle ist dabei so ausgebildet, dass eine Plasmakammer, von einem Mikrowellen-Resonator umschlossen ist. An einer Stirnfläche der Plasmakammer ist mindestens eine Plasmaaustrittsdüse ausgebildet und es sind außerdem Zuführungen für ein Plasmagas und ein Wandspülgas vorhanden. Zusätzlich ist in der Plasmakammer ein Plasmaformungselement angeordnet, mit dem das für die Plasmabildung nutzbare Innenvolumen der Plasmakammer reduziert werden kann. Dadurch wird bei der Plasmabildung eine quasi Verdichtung des Plasmas erreicht und ein annähernd scheibenförmiges Plasma innerhalb des verbliebenen Innenvolumens der Plasmakammer, im Gegensatz zu dem üblicherweise in Form eines Rotationsellipsoids oder einer Kugel ausgebildeten Plasmas, geformt werden.

Mit Hilfe des Plasmaformungselementes kann eine unsymmetrische Ausbildung des Innenvolumens der Plasmakammer in Bezug zum Mikrowellen-Resonator erreicht werden.

In einer besonders bevorzugten Ausführungsform kann das Plasmaformungselement parallel zur Mittenachse der Plasmakammer verschiebbar ausgebildet sein, so dass das für die Plasmabildung nutzbare Innenvolumen, wie auch der eigentliche Plasmabildungsprozess beeinflusst werden können.

Üblicherweise sollte ein Mikrowellen-Resonator mittig zwischen den Stirnflächen der Plasmakammer angeordnet werden.

Das Plasmaformungselement kann dann zwischen Umkehrpunkten innerhalb eines Justierbereiches in der Plasmakammer stufenlos verschoben werden, so dass optimale Bedingungen bei der Plasmabildung erreicht werden können, wenn das Plasmaformungselement in eine entsprechend günstige Position verschoben worden ist.

Bevorzugt sollten die Umkehrpunkte bei einem 1/4 und bei 3/4 der Höhe der Plasmakammer angeordnet sein, wobei die Höhe durch den Abstand der beiden sich gegenüberliegend angeordneten Stirnflächen der Plasmakammer vorgegeben ist. Bei der Anordnung der jeweiligen Umkehrpunkte können Toleranzen von bis zu ± 20% zugelassen werden.

Besonders bevorzugt ist eine Lage in halber Höhe des Resonatorzylinders, in Höhe der Schlitzantennen zur Einkopplung der Mikrowellenstrahlung. Dadurch kann die Plasmakammer mit dem Plasmaformungselement mittig geteilt sein und so das halbe Innenvolumen genutzt werden.

Der innere freie Querschnitt der Plasmakammer sollte bevorzugt kreisförmig sein, wobei auch andere Geometrien wie rechteckige oder ellipsenförmige freie Querschnitte ebenfalls zugelassen sein können.

Die bereits angesprochenen Zuführungen für ein Wandspülgas und ein Plasmagas können am und/oder im Plasmaformungselement angeordnet bzw. ausgebildet sein.

Dabei sollte die Zuführung für das Wandspülgas am radial äußeren Rand des Plasmaformungselementes angeordnet bzw. ausgebildet sein. So kann beispielsweise das Wandspülgas über einen Ringspalt, der im radial äußeren Randbereich des Plasmaformungselementes angeordnet ist, in die Plasmakammer zugeführt werden und dann bevorzugt parallel entlang der inneren Mantelfläche der Plasmakammer in Richtung auf die Stirnfläche, in der die mindestens eine Plasmaaustrittsdüse ausgebildet ist, strömen.

In einer Alternative kann aber das Plasmaformungselement so dimensioniert sein, dass zwischen seinem äußeren radialen Rand und der inneren Mantelfläche der Plasmakammer ein Abstand, der einen Ringspalt bildet, vorhanden ist, durch den das Wandspülgas in die Plasmakammer entsprechend einströmen kann.

In einer weiteren Alternative können aber auch Wandspülgasaustrittsöffnungen in äquidistanter Kreisringanordnung am radial äußeren Randbereich des Plasmaformungselementes ausgebildet sein, über die das Wandspülgas in die Plasmakammer einführbar ist.

Zumindest eine Zuführung für Plasmagas sollte durch das Plasmaformungselement in die Plasmakammer geführt sein, wobei lediglich eine solche Zuführung dann möglichst in der Mittenachse des Plasmaformungselementes und der Plasmakammer angeordnet sein sollte.

Günstiger ist es jedoch mehrere solcher Zuführungen an einem Plasmaformungselement vorzusehen, die symmetrisch in Bezug zur Mittenachse von Plasmaformungselement und Plasmakammer, bevorzugt rotationssymmetrisch um diese Mittenachse angeordnet sein sollten.

So besteht die Möglichkeit solche Zuführungen durch das Plasmaformungselement in einer Kreisringanordnung einzelner Düsen, die wiederum bevorzugt äquidistant zueinander angeordnet sind, auszubilden. Es können aber auch mehrere solcher Kreisringanordnungen mit unterschiedlichen Durchmessern um die Mittenachse mit entsprechenden Einzeldüsen ausgebildet sein, wobei dann in jeweils benachbarten Kreisringen eine versetzte Anordnung der einzelnen Düsen zueinander zu bevorzugen ist.

Durch solche Düsen oder Zuführungen kann ausschließlich Plasmagas in die Plasmakammer eingeführt werden. Es besteht aber auch die Möglichkeit ein Gemisch aus Plasmagas und mindestens einem Precursor in die Plasmakammer einzuführen.

Ein oder mehrere Precursoren können aber auch getrennt vom Plasmagas über gesonderte Zuführungen bzw. Düsen über das Plasmaformungselement der Plasmakammer zugeführt werden.

Die in das Innere der Plasmakammer weisende Oberfläche des Plasmaformungselementes kann als ebene planare Fläche ausgebildet sein.

In bestimmten Fällen kann es aber auch vorteilhaft sein, diese Oberfläche des Plasmaformungselementes in gewölbter Form, also konkav bzw. konvex auszubilden, so dass mit einer entsprechenden Oberflächenkontur des Plasmaformungselementes zusätzlich Einfluss auf die Formung des innerhalb der Plasmakammer gebildeten Plasmas und gegebenenfalls auch der Strömungsverhältnisse innerhalb der Plasmakammer genommen werden kann.

Das an einer erfindungsgemäßen Mikrowellenplasmaquelle einzusetzende Plasmaformungselement sollte bevorzugt aus einem elektrisch leitenden Werkstoff, beispielsweise einem Metall, gegebenenfalls aber auch aus einer elektrisch leitenden Keramik gebildet sein. Nachfolgend soll die Erfindung beispielhaft näher erläutert werden.

Dabei zeigt:

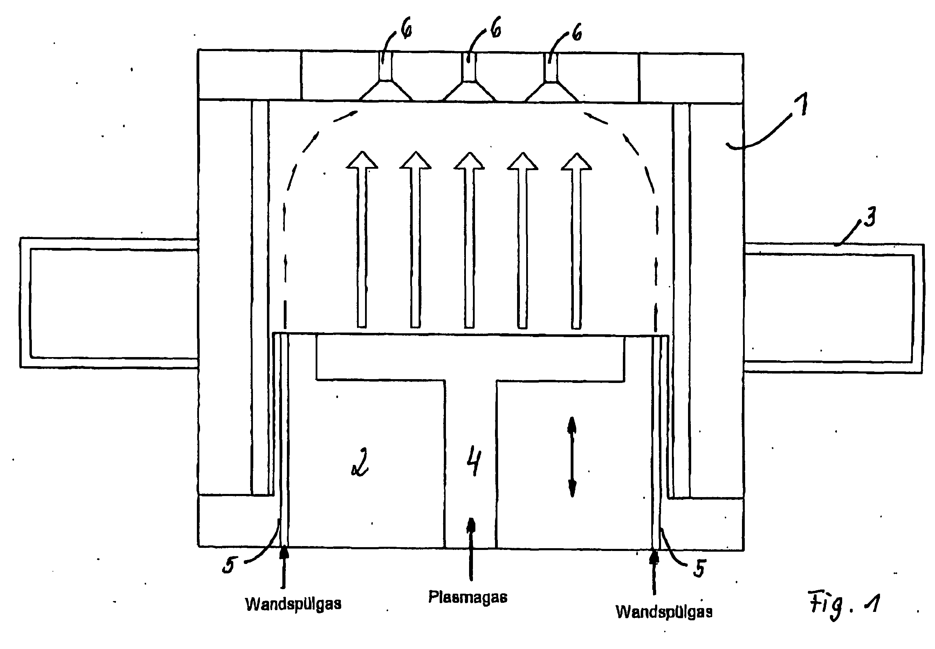

- Figur 1: in einer schematischen Darstellung ein Bei- spiel einer erfindungsgemäßen Mikrowel- lenplasmaquelle.

Bei der in Figur 1 gezeigten Mikrowellenplasmaquelle ist eine Plasmakammer 1 von einem Mikrowellen-Resonator 3 umschlossen.

Die Plasmakammer 1 hat einen rotationssymmetrischen Querschnitt, so dass sich das Innere der Plasmakammer 1, als zylinderförmiges Innenvolumen ergibt.

Der Mikrowellen-Resonator 3 ist zumindest ca. mittig zwischen der oberen Stirnseite und der unteren Stirnseite der Plasmakammer 1 angeordnet.

Im Inneren der Plasmakammer 1 ist ein Plasmaformungselement 2 angeordnet, mit dem das für die Plasmabildung nutzbare Innenvolumen der Plasmakammer 1 reduziert worden ist.

Wie mit dem Doppelpfeil angedeutet, kann das Plasmaformungselement 2 translatorisch verschoben werden, so dass eine Beeinflussung des für die Plasmabildung nutzbaren Innenvolumens der Plasmakammer 1 möglich ist. In jedem Fall ist aber mittels des Plasmaformungselementes 2 das Innenvolumen der Plasmakammer 1 in Bezug zum Mikrowellen-Resonator 3 unsymmetrisch ausgebildet.

Am radial äußeren Rand des Plasmaformungselementes 2 sind über dessen Umfang umlaufend Zuführungen 5 für Wandspülgas ausgebildet, wobei eine Zuführung beispielsweise in Form eines umlaufenden Ringspaltes ausgebildet sein kann.

Des Weiteren ist durch das Plasmaformungselement 2 eine Zuführung 4 für Plasmagas in das Innere der Plasmakammer 1 hindurchgeführt. Diesem Plasmagas kann, wie bereits im allgemeinen Teil der Beschreibung darauf hingewiesen worden ist, zusätzlich mindestens ein Prekursor zugeführt sein.

Das mit dem Plasmagas unter Nutzung der Mikrowellenenergie gebildete Plasma und weitere gegebenenfalls durch Modifizierung mit dem Plasma erhaltene Stoffe können über die an der hier oberen Stirnseite der Plasmakammer 1 ausgebildeten Plasmaaustrittsdüsen 6 austreten und beispielsweise für die Modifizierung von Substratoberflächen benutzt werden.

Mit dem Plasma können auch in situ erhaltene Stoffe, die partikelförmig sind, über die Plasmaaustrittsdüsen 6 ausgetrieben werden.

Da mit der erfindungsgemäßen Mikrowellenplasmaquelle ein gleichmäßiger Austrieb von Plasma und gebildeten Partikeln erreichbar ist, weisen die gebildeten Partikel ein sehr geringes Korngrößenspektrum um einen Mittelwert auf, so dass eine zumindest nahezu konstante Partikelgröße erreicht werden kann. Dies wird insbesondere dadurch erreicht, dass die einzelnen in die Plasmakammer 1 zugeführten Komponenten eine nahezu konstante Verweilzeit in der Plasmakammer 1 aufweisen, bevor sie über die Plasmaaustrittsdüsen 6 aus der Plasmakammer 1 ausgetrieben werden.

## Patentansprüche

1. Mikrowellenplasmaquelle mit einer Plasmakammer, die von einem Mikrowellen-Resonator umschlossen ist, dabei an einer Stirnfläche der Plasmakammer mindestens eine Plasmaaustrittsdüse ausgebildet ist und mindestens eine Zuführung für ein Plasmagas vorhanden sind,
**dadurch gekennzeichnet, dass**
in der Plasmakammer (1) ein Plasmaformungselement (2) angeordnet ist, mit dem das für die Plasmabildung nutzbare Innenvolumen der Plasmakammer (1) reduziert und **dadurch** das Innenvolumen der Plasmakammer (1) in Bezug zum Mikrowellen-Resonator (3) unsymmetrisch ausgebildet ist.

2. Mikrowellenplasmaquelle nach Anspruch 1,
**dadurch gekennzeichnet, dass** mindestens eine Zuführung (5) für ein Wandspülgas vorhanden ist.

3. Mikrowellenplasmaquelle nach einem der vorhergehenden Ansprüche, **dadurch gekennzeichnet, dass** das Plasmaformungselement (2) parallel zur Mittenachse der Plasmakammer (1) verschiebbar ist.

4. Mikrowellenplasmaquelle nach einem der vorhergehenden Ansprüche, **dadurch gekennzeichnet, dass** der radial äußere Rand eine Zuführung für ein Wandspülgas bildet und/oder am radial äußeren Rand mindestens eine Zuführung (5) für Wandspülgas angeordnet ist, und mindestens eine weitere Zuführung (4) für Plasmagas durch das Plasmaformungselement (2) in die Plasmakammer (1) geführt ist.

5. Mikrowellenplasmaquelle nach einem der vorhergehenden Ansprüche, **dadurch gekennzeichnet, dass** das Plasmaformungselement (2) zwischen Umkehrpunkten innerhalb eines Justierbereiches in der Plasmakammer (1) stufenlos verschiebbar ist.

6. Mikrowellenplasmaquelle nach einem der vorhergehenden Ansprüche, **dadurch gekennzeichnet, dass** die Umkehrpunkte bei 1/4 und 3/4 der Höhe der Plasmakammer mit einer Toleranz von ± 20% angeordnet sind.

7. Mikrowellenplasmaquelle nach einem der vorhergehenden Ansprüche, **dadurch gekennzeichnet, dass** die Plasmakammer (1) mit dem Plasmaformungselement (2) mittig geteilt ist.

8. Mikrowellenplasmaquelle nach einem der vorhergehenden Ansprüche, **dadurch gekennzeichnet, dass** die in das Innere der Plasmakammer (1) weisende Oberfläche des Plasmaformungselementes (2) als ebene planare Fläche ausgebildet ist.

9. Mikrowellenplasmaquelle nach einem der vorhergehenden Ansprüche, **dadurch gekennzeichnet, dass** die in das Innere der Plasmakammer (1) weisende Oberfläche des Plasmaformungselementes (2) als gewölbte Fläche ausgebildet ist.

10. Mikrowellenplasmaquelle nach einem der vorhergehenden Ansprüche, **dadurch gekennzeichnet, dass** durch das Plasmaformungselement (2) mindestens eine weitere Zuführung für mindestens einen Prekursor ausgebildet und/oder mindestens ein Prekursor gemeinsam mit dem Plasmagas in die Plasmakammer (1) zuführbar ist.

11. Mikrowellenplasmaquelle nach einem der vorhergehenden Ansprüche, **dadurch gekennzeichnet, dass** die Zuführung (5) für Wandspülgas als radial umlaufender Ringspalt oder mit einer Mehrzahl von Düsen in äquidistanter Kreisringanordnung ausgebildet ist.

12. Mikrowellenplasmaquelle nach einem der vorhergehenden Ansprüche, **dadurch gekennzeichnet, dass** die Zuführung (4) für Plasmagas und/oder Precursor mit Düsen am Plasmaformungselement (2) in einer rotationssymmetrischen Anordnung um die Mittenachse der Plasmakammer (1) ausgebildet ist.

13. Mikrowellenplasmaquelle nach einem der vorhergehenden Ansprüche, **dadurch gekennzeichnet, dass** das Plasmaformungselement (2) aus einem elektrisch leitenden Werkstoff gebildet ist.

## Claims

1. A microwave plasma source with a plasma chamber which is surrounded by a microwave resonator, wherein on an end face of the plasma chamber at least one plasma exit nozzle is formed and at least one supply means for a plasma gas are present, **characterised in that**
a plasma formation element (2) is arranged in the plasma chamber (1), with which element the internal volume of the plasma chamber (1) which is usable for the plasma formation is reduced and thereby the internal volume of the plasma chamber (1) is formed non-symmetrically in relation to the microwave resonator (3).

2. A microwave plasma source according to Claim 1, **characterised in that** at least one supply means (5) for a wall scavenging gas is present.

3. A microwave plasma source according to one of the preceding claims, **characterised in that** the plasma formation element (2) is displaceable parallel to the centre line of the plasma chamber (1).

4. A microwave plasma source according to one of the preceding claims,
**characterised in that** the radially outer edge forms a supply means for a wall scavenging gas and/or at least one supply means (5) for wall scavenging gas is arranged on the radially outer edge, and
at least one further supply means (4) for plasma gas is guided through the plasma formation element (2) into the plasma chamber (1).

5. A microwave plasma source according to one of the preceding claims, **characterised in that** the plasma formation element (2) can be displaced continuously variably in the plasma chamber (1) between reversal points within an adjustment range.

6. A microwave plasma source according to one of the preceding claims, **characterised in that** the reversal points are arranged at 1/4 and 3/4 of the height of the plasma chamber with a tolerance of ±20%.

7. A microwave plasma source according to one of the preceding claims, **characterised in that** the plasma chamber (1) is centrally divided with the plasma formation element (2).

8. A microwave plasma source according to one of the preceding claims, **characterised in that** the surface of the plasma formation element (2) which faces into the interior of the plasma chamber (1) is formed as a flat planar surface.

9. A microwave plasma source according to one of the preceding claims, **characterised in that** the surface of the plasma formation element (2) which faces into the interior of the plasma chamber (1) is formed as a curved surface.

10. A microwave plasma source according to one of the preceding claims, **characterised in that** at least one further supply means for at least one precursor is formed by the plasma formation element (2) and/or at least one precursor together with the plasma gas can be supplied into the plasma chamber (1).

11. A microwave plasma source according to one of the preceding claims, **characterised in that** the supply means (5) for wall scavenging gas is formed as a radially circumambient annular gap or with a plurality of nozzles in an equidistant circular ring arrangement.

12. A microwave plasma source according to one of the preceding claims, **characterised in that** the supply means (4) for plasma gas and/or precursor is formed with nozzles on the plasma formation element (2) in a rotationally symmetrical arrangement about the centre line of the plasma chamber (1).

13. A microwave plasma source according to one of the preceding claims, **characterised in that** the plasma formation element (2) is formed from an electrically conductive material.

## Revendications

1. Source de plasma à micro-ondes comprenant une chambre de plasma, cette dernière étant entourée d'un résonateur micro-ondes et présentant, sur une face frontale de la chambre de plasma, au moins une buse de sortie du plasma et au moins une conduite d'alimentation de gaz de plasma,
**caractérisée en ce que**
dans la chambre de plasma (1) est positionné un élément de formation de plasma (2), lequel réduit le volume intérieur de la chambre de plasma (1) utilisable pour la formation du plasma et, par conséquent, confère, au volume intérieur de la chambre de plasma (1), une forme asymétrique par rapport au résonateur micro-ondes (3).

2. Source de plasma à microondes selon la revendication 1, **caractérisée en ce qu'**il existe au moins une conduite d'alimentation (5) en gaz de balayage pour le nettoyage des parois.

3. Source de plasma à micro-ondes selon l'une quelconque des revendications précédentes, **caractérisée en ce que** l'élément de formation de plasma (2) peut être coulissé parallèlement à l'axe central de la chambre de plasma (1).

4. Source de plasma à micro-ondes selon l'une quelconque des revendications précédentes, **caractérisée en ce que** le bord extérieur radial forme une conduite d'alimentation d'un gaz de balayage pour le nettoyage des parois et/ou **en ce que** sur le bord extérieur radial, au moins une conduite d'alimentation (5) de gaz de balayage pour le nettoyage des murs est aménagée, et
qu'au moins une autre alimentation (4) en gaz de plasma est conduite dans la chambre de plasma (1) à travers l'élément de formation de plasma (2).

5. Source de plasma à micro-ondes selon l'une quelconque des revendications précédentes, **caractérisée en ce que** l'élément de formation de plasma (2) peut être coulissé en continu entre des points d'inversion à l'intérieur d'une zone d'ajustement dans la chambre de plasma (1).

6. Source de plasma à microondes selon l'une quelconque des revendications précédentes, **caractérisée en ce que** les points d'inversion sont positionnés à ¼ et à ¾ de la hauteur de la chambre de plasma avec une tolérance de ± 20%.

7. Source de plasma à microondes selon l'une quelconque des revendications précédentes, **caractérisée en ce que** la chambre de plasma (1) est divisée en son milieu par l'élément de formation de plasma (2).

8. Source de plasma à microondes selon l'une quelconque des revendications précédentes, **caractérisée en ce que** la surface de l'élément de formation de plasma (2) tournée vers l'intérieur de la chambre de plasma (1) se présente sous la forme d'une surface plane et nivelée.

9. Source de plasma à microondes selon l'une quelconque des revendications précédentes, **caractérisée en ce que** la surface de l'élément de formation de plasma (2) tournée vers l'intérieur de la chambre à plasma (1) se présente sous la forme d'une surface courbée.

10. Source de plasma à microondes selon l'une quelconque des revendications précédentes, **caractérisée en ce qu'**au moins une autre conduite pour au moins un gaz précurseur est formée à travers l'élément de formation de plasma (2) et/ou **en ce qu'**au moins un gaz précurseur peut être conduit conjointement avec le gaz de plasma dans la chambre de plasma (1).

11. Source de plasma à microondes selon l'une quelconque des revendications précédentes, **caractérisée en ce que** la conduite d'alimentation (5) de gaz de balayage pour le nettoyage des parois se présente sous la forme d'un interstice annulaire disposé radialement ou d'une pluralité de buses équidistantes agencées en cercle.

12. Source de plasma à microondes selon l'une quelconque des revendications précédentes, **caractérisée en ce que** la conduite d'alimentation (4) de gaz de plasma et/ou de gaz précurseur se présente sous forme de buses, disposées à symétrie de rotation autour de l'axe central de la chambre de plasma (1), au niveau de l'élément de formation de plasma (2).

13. Source de plasma à microondes selon l'une quelconque des revendications précédentes, **caractérisée en ce que** l'élément de formation de plasma (2) est constitué d'un matériau électroconducteur.
